# EUROPÄISCHE PATENTANMELDUNG

(11) **EP 0 631 148 A1**
(43) Veröffentlichungstag der Anmeldung: **28.12.1994**
(21) Anmeldenummer: 94250150.3
(22) Anmeldetag: 10.06.1994
(51) Int. Cl.: G01R 31/06

(54) **Verfahren zur berührungslosen Lötstellenprüfung**

(30) Priorität: 25.06.1993 DE 4321613
(71) Anmelder: SIEMENS AKTIENGESELLSCHAFT, D-80333 München (DE)
(72) Erfinder: Humke, Ralf, Dr., D-13089 Berlin (DE)

(57) **Zusammenfassung**

Die Erfindung betrifft ein Verfahren zur berührungslosen Prüfung der Lötstellen von Spulen (SP), insbesondere zur Güteanalyse von auf Spulenanschlußstiften automatisch aufgewickelten und verlöteten Spulendrahtenden.

Eine Farbbildkamera (FBK) und eine Schwarzweißbildkamera (SWK) tasten die Spulenanschlußstifte im Bereich einer diese umgebenden Ringleuchte (RL) hinsichtlich Farbe und Kontur der Lötstelle ab. Ein derartiges Verfahren wird zur optischen Lötstellenprüfung eingesetzt.

## Beschreibung

Die Erfindung betrifft ein Verfahren zur berührungslosen Prüfung der Lötstellen von Spulen, insbesondere zur Güteanalyse von auf Spulenanschlußstiften automatisch aufgewickelten und verlöteten Spulendrahtenden.

Optoelektronische Verfahren zu Prüfzwecken von Lötstellen sind aus der DE 32 12 190 A1 bekannt. Hier werden allerdings Lötbahnen auf Leiterplatten untersucht, in dem eindeutige Unterscheidungsmerkmale zwischen dem Isolationsbereich der Leiterplatte und dem Lötbereich einer Lötstelle ermittelt und mittels "Mustervergleich" eine entsprechende Auswertung vorgenommen werden. Dieses bekannte Verfahren beruht im wesentlichen auf die räumliche Erfassung und die Interpretation des Streulichtes von verschiedenen Flächen - metallische und nichtmetallische - mittels optoelektronischer Komponenten.

Aus der DE 38 26 735 ist darüber hinaus ein optoelektronisches Verfahren zur Prüfung von Flachbaugruppen bekannt, mit dem eine sog. Stückanalyse durch Bestimmung bestimmter geometrischer Kennwerte aus dreidimensionalen Oberflächenkoordinaten der Flachbaugruppe durchgeführt wird. Ein sich daran anschließender Vergleich der so ermittelten Ist-Struktur mit einer vorgegebenen Soll-Struktur ermöglicht zumindest eine Aussage über den Ähnlichkeitsgrad der zu prüfenden Flachbaugruppe mit einer vorgegebenen Musterstruktur.
Die der Erfindung zugrundeliegende Aufgabe besteht darin, diese bekannten Verfahren dahingehend zu erweitern, daß Lötstellen von Spulen, bzw. die Lötungen auf den sog. Anschlußstiften derselben, hinsichtlich ihrer optischen Ausgestaltung bewertbar gemacht werden können. Erfindungsgemäß wird dies dadurch erreicht, daß die Spulen mittels einer Werkstückträgereinrichtung in den Zentralbereich einer Ringleuchte verfahrbar sind, daß zur Detektierung der Lötstellen mittels einer Bildverarbeitungs- und Auswerteeinrichtung eine Farbbildkamera annähernd rechtwinklig zur Transportrichtung der Spulen in der Ebene des Zentralbereichs der Ringleuchte positionierbar ist und daß die Farbbildkamera die Lötstellen hinsichtlich Kontur und Farbe abtastet.

Mit dem Einsatz der Farbbildkamera und deren Positionierung in der angegebenen Weise ist neben einer an sich bekannten Konturerfassung zusätzlich eine bereichsspezifische Farbanalyse entlang des Anschlußstiftes der Spule ermöglicht, mit der die charakteristischen Farbunterschiede von gelöteten Windungen - silberfarbig - und von ungelöteten Windungen - kupferfarbig - erfaßt und ausgewertet werden können. Die Ringleuchte, in deren Zentralbereich die zu bewertende Lötstelle hereingefahren wird, beleuchtet den zu bewertenden Bereich so ausreichend, daß sämtliche Unterscheidungsmerkmale, wie die Form der Lötstelle, der Lötbereich und die Farbunterscheidungskriterien, deutlich erfaßbar sind.

Gemäß einer vorteilhaften Ausgestaltung der Erfindung ist vorgesehen, daß in der Ebene des Zentralbereichs der Ringleuchte eine im Winkelbereich von ca. 30° zur Farbbildkamera versetzt angeordnete grautonerfassende Schwarzweißbildkamera zur Abtastung der Kontur der Lötstellen einsetzbar ist. Mit der in diesem Winkelbereich angeordneten Schwarzweißbildkamera lassen sich die Konturen der Lötstelle noch deutlicher und genauer erfassen, da die Lötstellen praktisch dreidimensional abtastbar sind. Um die Prüfzeit derartiger Lötstellen zu verringern, bzw. die Durchlaufzeit der Spulen durch den Prüfvorgang zu verkürzen, ist gemäß einer weiteren vorteilhaften Ausgestaltung der Erfindung vorgesehen, daß die Kombination der Farbbildkamera mit der Schwarzweißbildkamera im Prüfzyklus mehrfach vorsehbar ist, und daß die Spulen von der Werkstückträgereinrichtung zu einem Rundschaltteller überführbar sind. Durch den Einsatz dieses Rundschalttellers kann in einer Zeiteinheit die doppelte Anzahl von Spulen geprüft werden.

Ein modifiziertes Prüfverfahren sieht vor, daß in der Ebene des Zentralbereiches der Ringleuchte eine im Winkelbereich von 90° zur Farbbildkamera versetzt angeordnete Schwarzweißbildkamera positionierbar ist, und daß die Spulen von der Werkstückträgereinrichtung zu einem Rundschaltteller überführbar und von diesem taktweise in den Bereich der Farbbildkamera und in den Bereich der Schwarzweißbildkamera schwenkbar sind und läßt sich gemäß einer weiteren vorteilhaften Ausgestaltung der Erfindung noch dadurch stärker automatisieren, in dem die Spulen nach dem Prüfvorgang mittels einer Spulenabzugseinrichtung gütesortiert vom Rundschaltteller entnehmbar und einer jeweiligen Magazinaufnahme zuführbar sind.

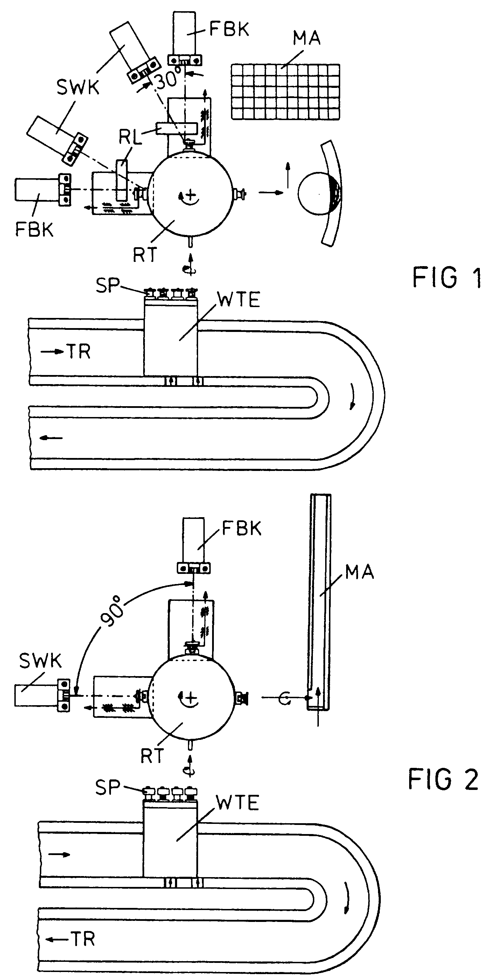

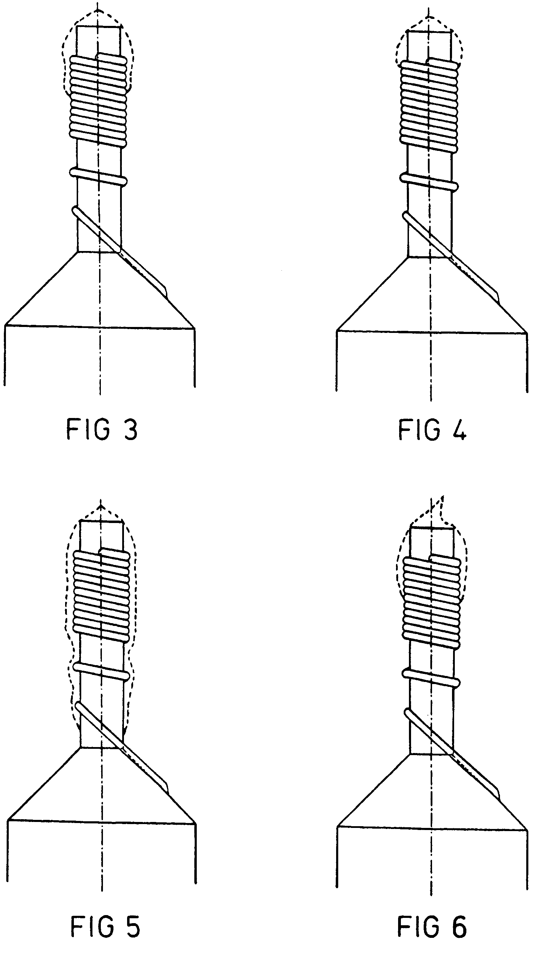

Die Erfindung wird durch zwei figürlich dargestellte Ausführungsbeispiele naher erläutert, wobei die Figur 1 ein teilautomatisch ablaufendes Verfahren zeigt, während die Figur 2 ein vollautomatisches Prüfverfahren repräsentiert. Die Figuren 3 bis 6 zeigen jeweils wesentliche Entscheidungskriterien zur Bewertung derartiger Lötstellen. Die Figur 1 stellt einen teilautomatisiert ablaufenden Prüfvorgang dar, bei dem die Spulen SP mit der Werkstückträgereinrichtung WTE entlang einer Transportstrecke mit der Transportrichtung TR verfahrbar sind. Zur Prüfung der Lötstellen werden die Spulen nacheinander aus der Werkstückträgereinrichtung WTE entnommen und zur Überprüfung der Lötstellen der Spulen SP von dem Rundschaltteller RT in den Zentralbereich der Ringleuchte RL verfahren. Annähernd rechtwinklig zur Transportstrecke ist die Farbbildkamera FBK positioniert, zu der in einem Winkelbereich von 30° die Schwarzweißbildkamera SWK angeordnet ist. Die sich im Zentralbereich der Ringleuchte RL befindende Lötstelle der Spule SP wird sowohl von der Farbbildkamera FBK als auch von der Schwarzweißbildkamera SWK erfaßt und entsprechend bewertet. Nach dem Prüfvorgang werden die geprüften Spulen manuell von dem Rundschaltteller entnommen und einer jeweiligen Magazinaufnahme MA zugeführt.

In den Figuren 3 bis 6 sind unterschiedliche Lötungen zu erkennen, wobei die Figuren 4 bis 6 fehlerhafte bzw. zu beanstandende Lötungen zeigen. Die gestrichelten Bereiche in den Figuren 3 bis 6 sollen jeweils das aufgebrachte Lötgut darstellen. Eine für gut befundene Lötung sieht entsprechend der Figur 3 so aus, daß annähernd die Hälfte der Windungen vom Lot bedeckt sind und im freien Endbereich des nicht bezeichneten Spulenanschlußstiftes eine kappenförmige Bedeckung entstanden ist.
In der Figur 4 ist eine Lötung dargestellt, bei der lediglich nur einige wenige Windungen des Spulenanschlußstiftes vom Lot umschlossen sind und dementsprechend keine ausreichend elektrische Leitbarkeit erreicht sein kann.
Die Figur 5 zeigt eine Lötstelle, bei der sich das Lot über die gesamten Windungen des Spulenanschlußstiftes ergibt, so daß die für die Spulenwicklung notwendige Zugentlastung durch die auslaufende Windung nicht mehr erreichbar ist.
Die Figur 6 zeigt eine Lötstelle, bei der im Endbereich des Spulenanschlußsiftes keine abgeflachte kappenförmige Bedeckung entstanden ist, sondern eine Lötspitze. Auch diese Art Lötstelle ist als fehlerhaft anzusehen.

In der Figur 2 ist ein vollautomatisch ablaufendes Verfahren schematisch dargestellt, in dem die Spulen SP ebenfalls über die Werkstuckträgereinrichtung WTE dem Rundschaltteller RT zugeführt werden. Auch hier werden die Spulen durch die Schwarzweißbildkamera SWK und die Farbbildkamera FBK geprüft, um anschließend mittels einer nicht dargestellten Spulenabzugseinrichtung gütesortiert einer jeweiligen Magazinaufnahme MA zugeführt. Zum Unterschied zum erstgenannten Verfahren werden hier die Spulen SP zu den im rechten Winkel angeordneten Aufnahmebereichen der Schwarzweißbildkamera SWK und der Farbbildkamera FBK nacheinander herangefahren.

Bei beiden Verfahren wird die bereichsspezifische Farbanalyse entlang der Spulenanschlußstifte durchgeführt, wobei die charakteristischen Farbunterschiede von gelöteten und ungelöteten Windungen entsprechend bewertet werden. Mit der Schwarzweißbildkamera SWK läßt sich die Kontur und Form der Lötung in besonders einfacher Weise auswerten.

## Patentansprüche

1. Verfahren zur berührungslosen Prüfung der Lötstellen von Spulen, insbesondere zur Güteanalyse von auf Spulenanschlußstiften automatisch aufgewickelten und verlöteten Spulendrahtenden,
**dadurch gekennzeichnet,**
daß die Spulen (SP) mittels einer Werkstückträgereinrichtung (WTE) in den Zentralbereich einer Ringleuchte (RL) verfahrbar sind,
daß zur Detektierung der Lötstellen mittels einer Bildverarbeitungs- und Auswerteeinrichtung eine Farbbildkamera (FBK) annähernd rechtwinklig zur Transportrichtung (TR) der Spulen (SP) in der Ebene des Zentralbereichs der Ringleuchte (RL) positionierbar ist und
daß die Farbbildkamera (FBK) die Lötstellen hinsichtlich Kontur und Farbe abtastet.

2. Verfahren nach Anspruch 1,
**dadurch gekennzeichnet,**
daß in der Ebene des Zentralbereichs der Ringleuchte (RL) eine im Winkelbereich von ca. 30° zur Farbbildkamera (FBK) versetzt angeordnete grautonerfassende Schwarzweißbildkamera (SWK) zur Abtastung der Kontur der Lötstellen einsetzbar ist.

3. Verfahren nach den Ansprüchen 1 und 2,
**dadurch gekennzeichnet,**
daß die Kombination der Farbbildkamera (FBK) mit der Schwarzweißbildkamera (SWK) im Prüfzyklus mehrfach vorsehbar ist, und
daß die Spulen (SP) von der Werkstückträgereinrichtung (WTE) zu einem Rundschaltteller (RT) überführbar sind.

4. Verfahren nach Anspruch 1,
**dadurch gekennzeichnet,**
daß in der Ebene des Zentralbereiches der Ringleuchte (RL) eine im Winkelbereich von 90° zur Farbbildkamera (FBK) versetzt angeordnete Schwarzweißbildkamera (SWK) positionierbar ist,
daß die Spulen (SP) von der Werkstückträgereinrichtung (WTE) zu einem Rundschaltteller (RT) überführbar und von diesem taktweise in den Bereich der Farbbildkamera (FBK) und in den Bereich der Schwarzweißbildkamera (SWK) schwenkbar sind.

5. Verfahren nach Anspruch 4,
**dadurch gekennzeichnet,**
daß die Spulen (SP) nach dem Prüfvorgang mittels einer Spulenabzugseinrichtung gütesortiert vom Rundschaltteller (RT) entnehmbar und einer jeweiligen Magazinaufnahme (MA) zuführbar sind.
